# EUROPEAN PATENT APPLICATION

(11) **EP 1 555 862 A2**
(43) Date of publication of application: **20.07.2005**
(21) Application number: 05001025.5
(22) Date of filing: 19.01.2005
(51) Int. Cl.: H05K 1/18, H01L 23/538

(54) **Process for producing circuit board having built-in electronic part**

(30) Priority: 19.01.2004 JP 2004010372
(71) Applicant: NITTO DENKO CORPORATION, Osaka (JP)
(72) Inventor: Uwada, Kazuki, Ibaraki-shi Osaka (JP); Hotta, Yuji, Ibaraki-shi Osaka (JP)
(74) Representative: Grünecker, Kinkeldey, Stockmair & Schwanhäusser Anwaltssozietät

(57) **Abstract**

The present invention provides a process for producing a circuit board (7) having built-in electronic parts (1), which comprises the steps of: disposing two wiring circuit boards (2) each having an electronic part (1) mounted thereon so that the electronic-part-mounting sides of the respective circuit boards (2) face each other; disposing a resin layer (3) between the circuit boards (2); and press-bonding the resin layer (3) to the circuit boards (2).

## Description

### FIELD OF THE INVENTION

The present invention relates to a process for producing a circuit board having built-in electronic parts.

### BACKGROUND OF THE INVENTION

With the recent trend toward size and weight reduction and performance advancement in electronic appliances, there is a growing desire for the higher-density mounting of electronic parts including semiconductor elements. In particular, the trend toward size and weight reduction in appliances represented by portable appliances or the like is thought to proceed further in the future. There is hence a desire for the development of a technique for mounting electronic parts in three-dimensional directions.

A circuit board having electronic parts built in an interlayer dielectric layer has been proposed as a technique to meet that desire (see, for example, patent document 1). This circuit board having built-in electronic parts is a multilayer wiring board which has an insulating layer formed from a material comprising a thermosetting resin and constituted by disposing electronic parts in spaces formed in the insulating layer.
Patent Document 1: JP 11-312868 A

However, the step for forming spaces beforehand in those areas of an insulating layer on which parts are to be mounted is troublesome and results in an increased production cost.

### SUMMARY OF THE INVENTION

Accordingly, an object of the invention is to provide a process by which a circuit board having built-in electronic parts can be easily produced.

Other objects and effects of the invention will become apparent from the following description.

Namely, the invention relates to:
(1)A process for producing a circuit board having built-in electronic parts, which comprises the steps of:
   disposing two wiring circuit boards each having an electronic part mounted thereon so that the electronic-part-mounting sides of the respective circuit boards face each other;
   disposing a resin layer between the circuit boards; and
   press-bonding the resin layer to the circuit boards;
(2) A process for producing a circuit board having built-in electronic parts, which comprises the step of:
   folding a wiring circuit board having two or more electronic parts mounted thereon; and
   disposing a resin layer in the resultant space between sections of the folded circuit board where electronic-part-mounting sides have come to face each other; and
   press-bonding the resin layer to the folded sections of the circuit board;
(3) The process for producing a circuit board having built-in electronic parts as described in item (1) or (2) above, wherein the resin layer comprises a polycarbodiimide; and
(4) The process for producing a circuit board having built-in electronic parts as described in item (3) above, wherein the polycarbodiimide comprises:
   n₁ pieces of structural units represented by general formula I: 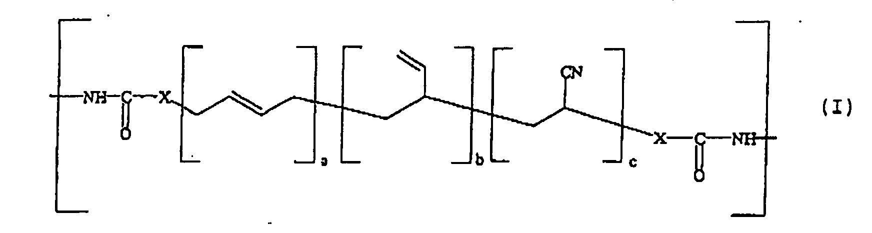 wherein a, b and c each are an integer of 0 to 200, provided that at least one of a, b and c is not 0, and X represents a single bond or an alkylene group having 1 to 5 carbon atoms;
   n₂ pieces of structural units represented by general formula II: 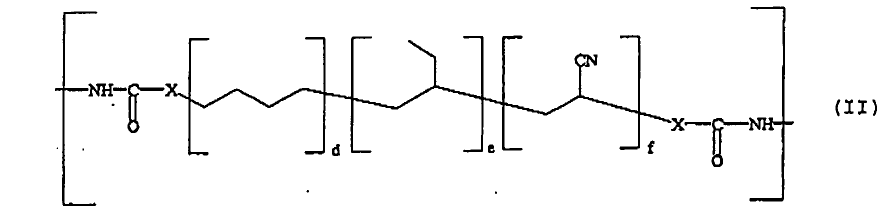 wherein d, e and f each are an integer of 0 to 200, provided that at least one of d, e and f is not 0, and X represents a single bond or an alkylene group having 1 to 5 carbon atoms; and
   n₃ pieces of structural units represented by general formula III: 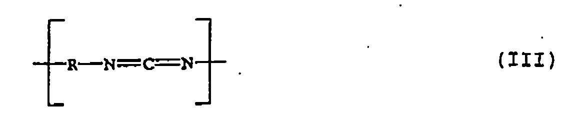 wherein R represents a bivalent organic group having 4 to 40 carbon atoms, and
      having terminal structural units obtained by reacting each end of the molecules with a monoisocyanate,
      wherein n₁+n₂ is an integer of 2 or larger, n₃ is an integer of 1 or larger, n₁+n₂+n₃ is 3 to 1,500, and (n₁+n₂) / (n₁+n₂+n₃) is from 1/100 to 1/3.

According to the invention, a circuit board having built-in electronic parts can be easily produced.

### BRIEF DESCRIPTION OF THE DRAWINGS

Fig. 1 is a sectional view of an example of a circuit board having built-in electronic parts produced by one embodiment of the process of the invention.
Fig. 2 is a sectional view of an example of a circuit board having built-in electronic parts produced by another embodiment of the process of the invention.
Fig. 3 is a sectional view of an example of a circuit board having built-in electronic parts produced by a still other embodiment of the process of the invention.

The reference numerals used in the drawings denotes the followings, respectively.
- 1:: Electronic part
- 2:: Wiring circuit board
- 3:: Resin layer
- 4:: Insulating layer
- 5:: Conductor layer
- 6:: Conduction path
- 7:: Circuit board having built-in electronic parts

### DETAILED DESCRIPTION OF THE INVENTION

The process for producing a circuit board having built-in electron parts in one embodiment of the invention comprises the steps of disposing two wiring circuit boards each having an electronic part mounted thereon so that the electronic-part-mounting sides of the respective circuit boards face each other, disposing a resin layer between the circuit boards, and press-bonding the resin layer to the circuit boards.

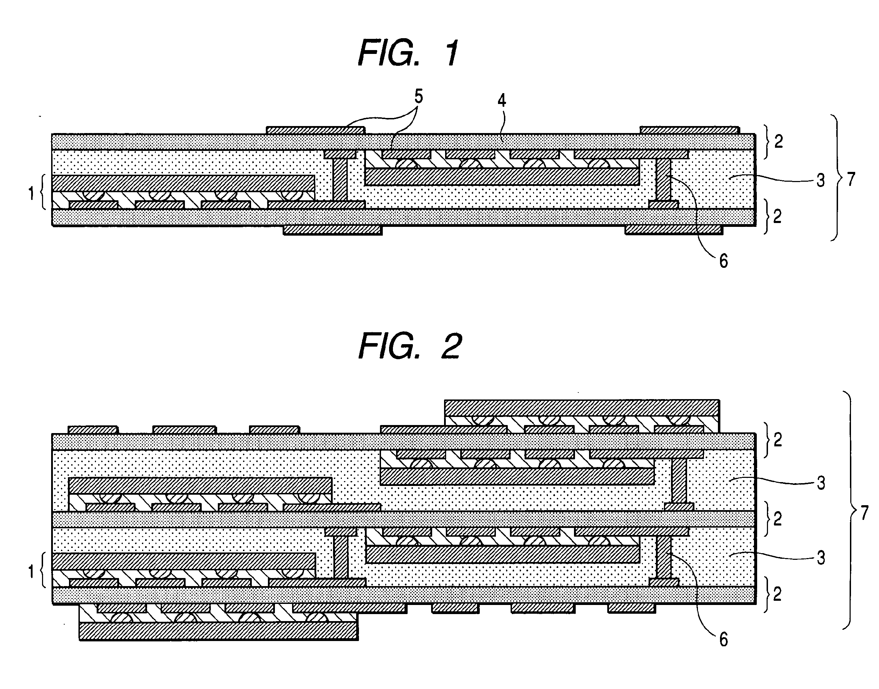

An example of the circuit board having built-in electronic parts which is produced by the process in this embodiment is shown in Fig. 1. This circuit board has a structure comprising two wiring circuit boards 2 each having an electronic part 1 mounted thereon and a resin layer 3 which is disposed between the circuit boards 2 and in which the electronic parts are embedded.

The embedding of electronic parts in a resin layer disposed between two wiring circuit boards can eliminate the conventional step of forming spaces for electronic part mounting in an insulating layer of a wiring circuit board. Simplification of steps can hence be attained.

The wiring circuit boards 2 to be used in this embodiment are not limited as long as they comprise an insulating layer 4 and a conductor layer 5 superposed thereon directly or through an adhesive, and known circuit boards may be used.

The insulating layer provided in the wiring circuit boards is not particularly limited. However, the insulating layer preferably is a film having a glass transition temperature higher than the curing temperature of the thermosetting resin to be used in the resin layer, which will be described later. Examples thereof include films of polyimide resins, aramid resins, fluororesins, and poly(ethylene terephthalate) resins.

The conductor layer in the wiring circuit boards is not particularly limited as long as it is one in ordinary use as a conductor layer. However, a copper foil is preferred from the standpoints of ease of processing and cost reduction. Usually, the conductor layer has been formed so as to have a given wiring pattern including a signal wiring and an electrode, and may have been formed on' one or each side of the insulating layer. The formation of the conductor layer so as to have a wiring pattern can be conducted by a known technique such as the subtractive method or additive method.

Examples of the electronic part 1 include semiconductor elements, resistive elements, and capacitor elements. Such an electronic part can be mounted on the wiring circuit boards by using a known technique, such as flip chip bonding, to bond the electronic part onto the conductor layer formed by the method shown above. In the case where the wiring circuit board has a conductor layer on each side thereof, an electronic part may be mounted on each side of the wiring circuit board.

The resin to be used for the resin layer 3 is preferably a thermosetting resin, more preferably a polycarbodiimide, from the standpoint of securing heat resistance.

Especially preferred of polycarbodiimides, from the standpoint of high conformability to the recesses and protrusions of electronic parts, is a polycarbodiimide which comprises:
n₁ pieces of structural units represented by general formula I: 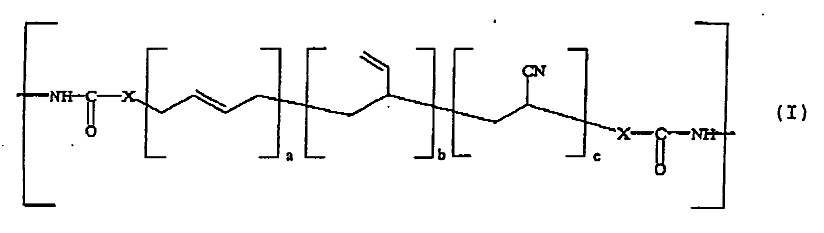 wherein a, b and c each are an integer of 0 to 200, provided that at least one of a, b and c is not 0, and X represents a single bond or an alkylene group having 1 to 5 carbon atoms;
n₂ pieces of structural units represented by general formula II: 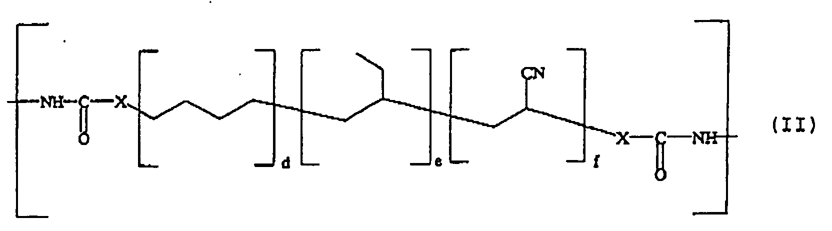 wherein d, e and f each are an integer of 0 to 200,
   provided that at least one of d, e and f is not 0, and X represents a single bond or an alkylene group having 1 to 5 carbon atoms;
n₃ pieces of structural units represented by general formula III: 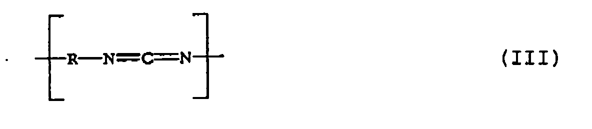 wherein R represents a bivalent organic group having 4 to 40 carbon atoms, and
having terminal structural units obtained by reacting each end of the molecules with a monoisocyanate,
wherein n₁+n₂ is an integer of 2 or larger, n₃ is an integer of 1 or larger, n₁+n₂+n₃ is 3 to 1,500, and (n₁+n₂)/(n₁+n₂+n₃) is from 1/100 to 1/3.

Symbols a, b, and c each are preferably 0 to 150, more preferably 0 to 100, from the standpoint of realizing high conformability to the recesses and protrusions of electronic parts. Symbols d, e, and f each are preferably 0 to 150, more preferably 0 to 100, from the standpoint of realizing high conformability to the recesses and protrusions of electronic parts.

X preferably represents a single bond or an alkylene group having 1 to 5 carbon atoms. Examples of the alkylene group having 1 to 5 carbon atoms include ethylene and propylene.

R preferably represents a divalent organic group having 4 to 40 carbon atoms, such as, e.g., an alkylene or arylene group having 4 to 40 carbon atoms. Examples of the alkylene group having 4 to 40 carbon atoms include hexamethylene, a 4,4'-dicyclohexylmethane diisocyanate residue group, and an isophorone diisocyanate residue group. Examples of the arylene group having 4 to 40 carbon atoms include tolylene and a 4,4'-diphenylmethane diisocyanate residue group.

From the standpoint of realizing high conformability to the recesses and protrusions of electronic parts, n₁, n₂, and n₃ are as follows. The value of n₁+n₂ is preferably an integer of 2 to 1,000, more preferably an integer of 2 to 100, especially preferably an integer of 2 to 10. Symbol n₃ is preferably an integer of 1 to 500, more preferably an integer of 1 to 300, especially preferably an integer of 70 to 100. The value of n₁+n₂+n₃ is preferably an integer of 70 to 100. The value of (n₁+n₂)/(n₁+n₂+n₃) is preferably from 1/15 to 1/3.

Examples of the terminal structural unit obtained by reacting a monoisocyanate include substituted or unsubstituted aryl or alkyl groups. Examples of the substituted aryl groups include tolyl, isopropylphenyl, methoxyphenyl, and chlorophenyl. Examples of the unsubstituted aryl groups include phenyl and naphthyl. Examples of the substituted alkyl groups include 2,2,4-trimethylhexyl. Examples of the unsubstituted alkyl groups include alkyl groups having 1 to 10 carbon atoms, such as n-butyl, n-hexyl, and n-octyl.

In the invention, the polycarbodiimide is obtained by subjecting one or more bifunctional liquid rubbers represented by general formula I' : 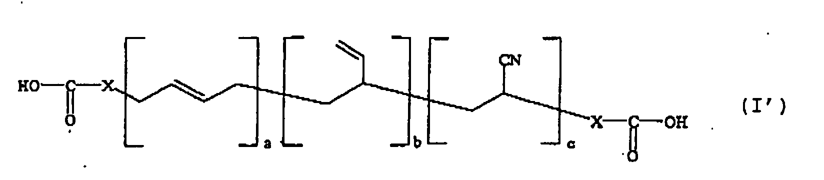 (wherein a, b and c each are an integer of 0 to 200, provided that at least one of a, b and c is not 0, and X represents a single bond or an alkylene group having 1 to 5 carbon atoms) and/or formula II': 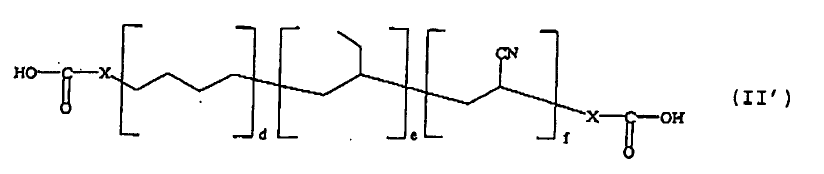 (wherein d, e and f each are an integer of 0 to 200, provided that at least one of d, e and f is not 0, and X represents a single bond or an alkylene group having 1 to 5 carbon atoms)
(these rubbers may be referred to simply as "bifunctional liquid rubbers" in this specification) to a condensation reaction with one or more diisocyanates and then blocking the terminals of the resultant condensate with a monoisocyanate.

Examples of the bifunctional liquid rubber represented by general formula I' include liquid polybutadiene (e.g., Hycar CTB (trademark), manufactured by Ube Industries, Ltd., and C-1000, manufactured by Nippon Soda Co., Ltd.) and liquid polybutadiene/acrylonitrile copolymers (e.g., Hycar CTBN (trademark), manufactured by Ube Industries, Ltd.). Examples of the bifunctional liquid rubber represented by general formula II' include liquid hydrogenated polybutadiene (e.g., CI-1000, manufactured by Nippon Soda Co., Ltd.). Each bifunctional liquid rubber may be used singly or two or more bifunctional liquid rubbers may be used in combination.

Examples of the diisocyanates to be used as a starting material include aromatic diisocyanates and aliphatic diisocyanates. These may be used singly or in a combination of two or more thereof.

Examples of the aromatic diisocyanates include compounds represented by general formula IV: 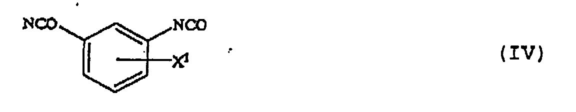 (wherein X¹ represents an alkyl or alkoxyl group having Ito 5 carbon atoms or a halogen atom),
such as 2,4-tolylene diisocyanate, 2,6-tolylene diisocyanate, 6-methoxy-2,4-phenylene diisocyanate, and 5-bromo-2,4-tolylene diisocyanate.

Examples of the aromatic diisocyanates further include compounds represented by general formula V: 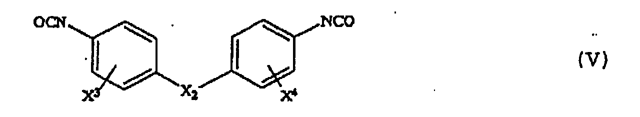 (wherein X² represents a single bond, an alkylene group having 1 to 5 carbon atoms, an oxygen atom, a sulfur atom, or S(=O); and X³ and X⁴ each represent an alkyl or alkoxyl group having 1 to 5 carbon atoms or a halogen atom), such as 4,9'-diphenylmethane diisocyanate, 3,3',5,5'-tetraethyl-4,4'-diphenylmethane diisocyanate, 4,4'-diphenylisopropylidene diisocyanate, 4,4'-diphenyl ether diisocyanate, 4,4'-diphenyl sulfide diisocyanate, 4,4'-diphenyl sulfoxide diisocyanate, 3,3',5,5'-tetramethyl-4,4'-biphenyl diisocyanate, 3,3'-dimethoxy-4,4'-biphenyl diisocyanate, and 3,3'-dibromo-4,4'-biphenyl diisocyanate.

Examples of the aliphatic diisocyanates include compounds represented by general formula VI: 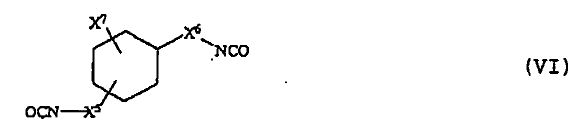 (wherein X⁵ and X⁶ each represent a single bond or an alkylene group having 1 to 5 carbon atoms and X⁷ represents an aliphatic hydrocarbon group having 1 to 8 carbon atoms), such as 4,4'-dicyclohexylmethane diisocyanate, norbornane diisocyanate, 4,4'-cyclohexane diisocyanate, isophorone diisocyanate, methylcyclohexane 2,4-diisocyanate, and 2,4-bis(isocyanatomethyl)cyclohexane.

Examples of the aliphatic diisocyanates further include compounds represented by general formula VII:

OCN-X⁸-NCO (VII)

(wherein X⁸ represents an alkylene group having 1 to 18 carbon atoms),
such as hexamethylene diisocyanate, 2,2,4-trimethylhexamethylene diisocyanate, octamethylene diisocyanate, and dodecamethylene diisocyanate.

Examples of the aliphatic diisocyanates furthermore include compounds represented by general formula VIII: 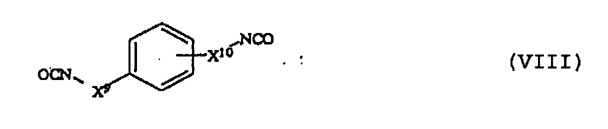 (wherein X⁹ and X¹⁰ each represent a single bond or an alkylene group having 1 to 5 carbon atoms),
such as xylylene diisocyanate, α,α,α',α'-tetramethylxylylene diisocyanate, and 4-isocyanatomethylphenyl isocyanate.

The bifunctional liquid rubbers respectively represented by general formulae I' and II' are used in such molar amounts as to be capable of satisfying the values of n₁ and n₂, respectively. In the case where the two rubbers are used in combination, the molar ratio between these, i.e., the ratio of n₁ to n₂ (n₁/n₂), is not particularly limited. The molar ratio of the bifunctional liquid rubbers to the diisocyanates (bifunctional liquid rubbers/diisocyanates) is preferably from 1/99 to 1/2, more preferably from 1/10 to 1/2.

In the case where an aromatic diisocyanate and an aliphatic diisocyanate are used in combination as the diisocyanates, the molar ratio of the aromatic diisocyanate to the aliphatic diisocyanate (aromatic diisocyanate/aliphatic diisocyanate) is preferably from 3/2 to 99/1, more preferably from 4/1 to 99/1.

Examples of the monoisocyanate to be used as a starting material include isocyanates having a substituted or unsubstituted aryl group, such as phenyl isocyanate, naphthyl isocyanate, tolyl isocyanate, isopropylphenyl isocyanate, methoxyphenyl isocyanate, and chlorophenyl isocyanate; and alkyl isocyanates in which the alkyl has 1 to 10 carbon atoms, such as n-butyl isocyanate, n-hexyl isocyanate, and n-octyl isocyanate. These may be used singly or in a combination of two or more thereof.

It is preferred that the monoisocyanate be used in an amount of 1 to 40 mol per 100 mol of the diisocyanate ingredient to be used. Use of the monoisocyanate ingredient in an amount of 1 mol or larger per 100 mol of the diisocyanate ingredient is preferred because the polycarbodiimide obtained neither has too high a molecular weight nor has undergone crosslinking reaction. Namely, for example, the polycarbodiimide solution obtained undergoes neither an increase in viscosity nor solidification nor a decrease in storage stability. On the other hand, use of the monoisocyanate ingredient in an amount of 40 mol or smaller per 100 mol of the diisocyanate ingredient is preferred because the resultant polycarbodiimide solution has an appropriate viscosity and, for example, film formation by the application and drying of the solution can be satisfactorily conducted. The polycarbodiimide solution obtained through terminal blocking with a monoisocyanate used in an amount within that range relative to the amount of the diisocyanate ingredient especially has excellent storage stability.

By using the ingredients in the respective proportions described above, a polycarbodiimide in which the values of n₁, n₂, and n₃ are within the respective ranges can be obtained.

Specifically, the polycarbodiimide is produced by reacting the bifunctional liquid rubber(s) as a starting material with a diisocyanate as another starting material in an aprotic solvent, subsequently subjecting the reaction product to a condensation reaction in the presence of a catalyst for carbodiimide formation to form a carbodiimide, and then blocking the terminals of the carbodiimide with a monoisocyanate.

The polycarbodiimide production described above is preferably conducted in the following manner. In toluene solvent, 70 parts by weight of the bifunctional liquid rubber is mixed with 30 parts by weight of tolylene diisocyanate. After this mixture is stirred at 50°C for 1 hour, 1-naphthyl isocyanate is mixed therewith in an amount of 2 mol per 100 mol of the tolylene diisocyanate. A catalyst for carbodiimide formation is added to the mixture. The temperature of the resultant mixture is elevated to 100°C and a carbodiimide-forming reaction is conducted at this temperature for about 2 hours to produce a polycarbodiimide. In selecting a reaction time, the end point of the carbodiimide-forming reaction can be determined, for example, by the method which will be described later.

The temperature for the reaction between the bifunctional liquid rubber and the diisocyanate is preferably 10 to 50°C, more preferably 30 to 50°C, from the standpoints of reaction time reduction and the prevention of thermal deterioration of the liquid rubber. The reaction time may be about from 30 minutes to 2 hours, and is usually about 1 hour. The end point of the reaction is ascertained from the disappearance of absorption by the OH stretching vibration (3,000 cm⁻¹) attributable to the terminal carboxyl groups of the bifunctional liquid rubber.

The temperature for the carbodiimide-forming reaction is preferably 10 to 150°C, more preferably 40 to 110°C. Carbodiimide-forming reaction temperatures not lower than 10°C are preferred because the reaction does not necessitate too long a time and gives a polycarbodiimide solution having no functional isocyanate groups remaining therein. This polycarbodiimide solution, for example, has improved storage stability. Reaction temperatures not higher than 150°C are preferred because the reaction does not proceed too rapidly and side reactions do not cause gelation, and because this, for example, results in a polycarbodiimide solution having improved storage stability.

Examples of the catalyst for carbodiimide formation include 3-methyl-1-phenyl-2-phospholene 1-oxide, 1-phenyl-2-phospholene 1-oxide, 1-phenyl-2-phospholene 1-sulfide, 1-ethyl-3-methyl-2-phospholene 1-oxide, 3-methyl-1-phenyl-1-phospha-3-cyclopentene 1-oxide, 2,5-dihydro-3-methyl-1-phenylphospholene 1-oxide, and the 3-phospholene isomers of these. Also usable are phosphine oxides such as triphenylphosphine oxide, tritolylphosphine oxide, and bis(oxadiphenylphosphino)ethane. These may be used singly or in a combination of two or more thereof.

It is preferred that the catalyst for carbodiimide formation be used in an amount in the range of 0.001 to 5 mol per 100 mol of all isocyanate ingredients to be used. Amounts of the catalyst not smaller than 0.001 mol are preferred because the reaction does not necessitate too long a time. Amounts thereof not larger than 5 mol are preferred because the gelation causative of too high a reaction rate does not occur and this, for example, results in an improvement in the storage stability of the polycarbodiimide solution.

The terminal blocking with a monoisocyanate can be accomplished by adding the monoisocyanate to the reaction mixture in an initial, middle, or final stage of carbodiimide formation or throughout the carbodiimide formation.

Examples of the aprotic solvent to be used for producing the polycarbodiimide include toluene, xylene, alkyltoluenes in which the alkyl has 3 to 5 carbon atoms, benzene, alkylbenzenes in which the alkyl has 3 to 6 carbon atoms, naphthalene, tetrahydrofuran, dioxane, acetone, butanone, cyclohexanone, N-methylpyrrolidone, N,N-dimethylformamide, and N,N-dimethylacetamide. These may be used singly or in a combination of two or more thereof.

It is preferred that the aprotic solvent be used in such an amount that the polycarbodiimide concentration in the resultant polycarbodiimide solution is in the range of 1 to 90% by weight. Polycarbodiimide concentrations not lower than 1% by weight are preferred because solvent removal in the molding of the polycarbodiimide obtained is easy. Polycarbodiimide concentrations not higher than 90% by weight are preferred because the polycarbodiimide solution has a moderate viscosity and improved storage stability.

The end point of the carbodiimide-forming reaction can be ascertained by infrared spectroscopy (IR analysis) from the occurrence of absorption by the stretching vibration of the atomic group N=C=N (2,135 cm⁻¹) in the polycarbodiimide yielded, the disappearance of absorption by the stretching vibration of the atomic group N=C=O (2,270 cm⁻¹) in the isocyanates, and the occurrence of absorption by the stretching vibration of the C=O (1,695 cm⁻¹) in the amide group at each linkage between the bifunctional liquid rubber and the diisocyanate.

After completion of the carbodiimide-forming reaction, a polycarbodiimide is obtained usually in the form of a solution. However, the solution obtained may be poured into a poor solvent such as methanol, ethanol, isopropyl alcohol, or hexane to precipitate the polycarbodiimide and remove the unreacted monomers and the catalyst.

In preparing a solution of the polycarbodiimide which has been recovered as a precipitate, the precipitate is washed and dried in a given manner and then dissolved again in an aprotic solvent. By performing this operation, the polycarbodiimide solution can have improved storage stability.

In the case where the polycarbodiimide solution contains by-products, the solution may be purified, for example, by adsorptively removing the by-products with an appropriate adsorbent. Examples of the adsorbent include alumina gel, silica gel, activated carbon, zeolites, activated magnesium oxide, activated bauxite, Fuller's earth, activated clay, and molecular sieve carbon. These may be used singly or in a combination of two or more thereof.

The resin thus obtained, which comprises a polycarbodiimide, has a curing temperature of preferably 120 to 250°C and a glass transition temperature of preferably 150 to 250°C.

The resin layer to be used in this embodiment comprises the thermosetting resin in an amount of generally 10 to 100% by weight, preferably 30 to 100% by weight.

The resin layer in this embodiment is preferably used as a resin film, although the form of the resin to be used is not particularly limited. The film is obtained by dissolving the polycarbodiimide in any of the aprotic solvents enumerated above, such as toluene or cyclohexanone, applying the resultant solution to a substrate by a known technique, e.g., casting, spin coating, or roll coating, and drying the coating with heating. The application of the solution is preferably conducted in such an amount as to give a film having a thickness of 10 to 300 µm.

The substrate may be any film having heat resistance and chemical resistance. Examples thereof include films of polyimides, polyesters, and poly(ethylene terephthalate). These polymers may be used singly or in a combination of two or more thereof. The film to be used as the substrate preferably is one which has been treated with a release agent such as, e.g., a fluorinated silicone.

The drying with heating of the polycarbodiimide solution applied to the substrate is preferably conducted under such temperature and time conditions that the solvent can be removed, for the purpose of drying the solution without causing the curing reaction of the polycarbodiimide to proceed excessively. Specifically, the drying temperature is preferably 30 to 200°C, more preferably 50 to 175°C, especially preferably 70 to 150°C. Drying temperatures not lower than 30°C are preferred because the resultant resin film contains no residual solvent and has high reliability. Drying temperatures not higher than 200°C are preferred because the resin film can be sufficiently dried while being inhibited from thermally curing. The time period of drying is preferably from 30 seconds to 30 minutes, more preferably 1 to 10 minutes, especially preferably 2 to 5 minutes. Drying times not shorter than 30 seconds are preferred because the resultant resin film contains no residual solvent and has high reliability. Drying times not longer than 30 minutes are preferred because the resin film can be sufficiently dried while being inhibited from thermally curing.

In producing the resin film, various nonconductive inorganic powders, e.g., powders of ceramics such as alumina, silica, magnesia, and silicon nitride, may be incorporated according to need for the purpose of modulus regulation, etc. Such powders may be used singly or in a combination of two or more thereof.

The resin film may suitably further contain an inorganic filler as long as this does not impair the processability and heat resistance of the layer. Furthermore, various additives such as a leveling agent or defoamer for obtaining surface smoothness, a silane coupling agent or titanate coupling agent for improving adhesion, a nonionic surfactant, a fluorochemical surfactant, and a silicone additive may have been added according to need. The amount of these additives to be added is preferably 0.1 to 100 parts by weight, more preferably 0.2 to 50 parts by weight, per 100 parts by weight of the polycarbodiimide.

Conduction paths 6 may be formed in the resin film in order to electrically connect the wirings of the wiring circuit boards to each other. The conduction paths are formed, for example, by forming through-holes extending in the direction of the thickness of the resin film by means of a laser, punching, drilling, etc. and filling the through-holes with a paste containing metal particles, e.g., copper particles or silver particles, by means of a dispenser, suction, screen printing, etc.

In this embodiment, the circuit board 7 having built-in electronic parts is produced by disposing two wiring circuit boards 2 each having an electronic part 1 mounted thereon so that the electronic-part-mounting sides of the respective circuit boards face each other, disposing a resin layer 3 between the circuit boards, and press-bonding the resin layer to the circuit boards, for example, by vacuum pressing.

For the disposition of the resin layer between the wiring circuit boards, use may be made of a method in which through-holes for positioning are formed beforehand in the circuit boards and the resin film, and pins for positioning are used to dispose the resin film.

The press-bonding of the resin layer to the circuit boards is conducted at a pressure of preferably 9.8×10⁻³ to 9.8×10⁻¹ MPa, more preferably 9.8×10⁻² to 4.9×10⁻¹ MPa, with heating at preferably 100 to 200°C, more preferably 140 to 170°C, for preferably from 5 seconds to 10 minutes, more preferably from 10 seconds to 1 minute. In this press-bonding operation, the electronic parts are embedded in the resin layer and the wiring circuit boards are electrically connected to each other by the conduction paths in the direction of superposition.

Thereafter, a wiring circuit board having an electronic part mounted thereon and a resin layer may be further superposed on the circuit board having built-in electronic parts produced above, as shown in Fig. 2. The number of circuit boards to be superposed may be adjusted according to the intended use.

After the wiring circuit boards have been press-bonded to the resin layer in the manner described above, the resultant structure is preferably further heated at a temperature of about 120 to 200°C for about 1 to 5 hours in order to completely cure the polycarbodiimide in the resin layer.

The process for producing a circuit board having built-in electronic parts in another embodiment of the invention comprises the steps of: folding a wiring circuit board having two or more electronic parts mounted thereon; disposing a resin layer in the resultant space between sections of the folded circuit board where electronic-part-mounting sides have come to face each other; and press-bonding the resin layer to the folded sections of the circuit board.

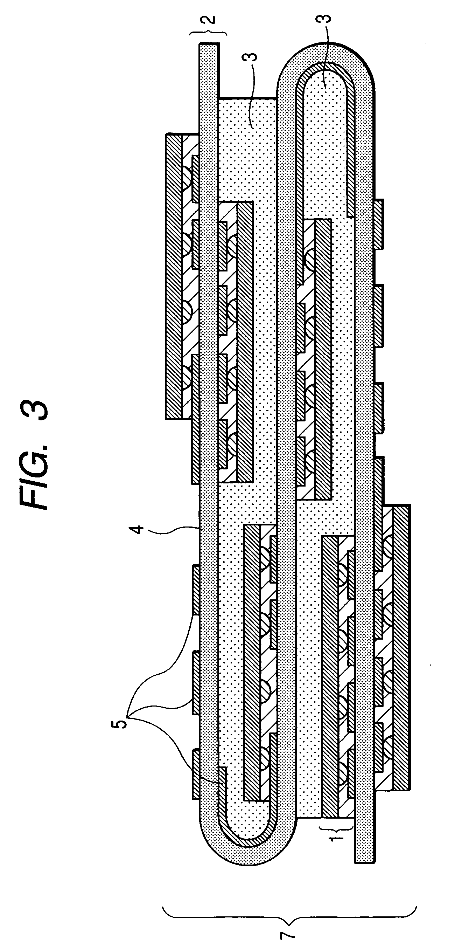

An example of the circuit board having built-in electronic parts which is produced by the process in this embodiment is shown in Fig. 3. This circuit board has a structure comprising: a wiring circuit board 2 which has two or more electronic parts 1 mounted thereon and has been folded; and a resin layer 3 which has been disposed between the folded sections of the circuit board and in which the electronic parts 1 have been embedded. The number of folds of the wiring circuit board may be determined according to the intended use.

In this embodiment, the wiring circuit board, electronic parts, and resin layer to be used may be the same as those described for the above-described embodiments. However, unlike the process described above, this process does not necessitate the formation of a conduction path in a resin layer for electrically connecting the wirings of wiring circuit boards, because only one common wiring circuit board is used.

In this embodiment, the circuit board 7 having built-in electronic parts is produced by preparing a wiring circuit board 2 having two or more electronic parts 1 mounted thereon, disposing a resin layer 3 in given positions on electronic-part-mounting sides, folding the wiring circuit board 2 so that the electronic-part-mounting sides face each other, and press-bonding the resin layer to the circuit board, for example, by vacuum pressing.

As in the process described above, the disposition of the resin layer on the wiring circuit board may be conducted by a method in which through-holes for positioning are formed beforehand in the circuit board and the resin film, and pins for positioning are used to dispose the resin film.

The press-bonding of the resin layer to the circuit board is conducted at a pressure of preferably 9.8×10⁻³ to 9.8×10⁻¹ MPa, more preferably 9.8×10⁻² to 4.9×10⁻¹ MPa, with heating at preferably 100 to 200°C, more preferably 140 to 170°C, for preferably from 5 seconds to 10 minutes, more preferably from 10 seconds to 1 minute. In this press-bonding operation, the electronic parts are embedded in the resin layer.

Another circuit board and a resin layer may be further superposed on the circuit board having built-in electronic parts produced in this embodiment. Such a circuit board having built-in electronic parts may be produced according to the intended use.

After the wiring circuit board has been press-bonded to the resin layer in the manner described above, the resultant structure is preferably further heated at a temperature of about 120 to 200°C for about 1 to 5 hours in order to completely cure the polycarbodiimide in the resin layer.

### EXAMPLE

The present invention will be illustrated in greater detail with reference to the following Example, but the invention should not be construed as being limited thereto.

In the following Example, all synthesis reactions were conducted in a nitrogen stream. IR analysis was made with FT/IR-230 (manufactured by JEOL Ltd.).

Into a 500-mL four-necked flask equipped with a stirrer, dropping funnel, reflux condenser, and thermometer were introduced 70.57 g (282 mmol) of 4,4'-diphenylmethane diisocyanate, 27.34 g (5.70 mmol) of Hycar CTB2000X162 (manufactured by B.F. Goodrich), 54.68 g (39.06 mmol) of NISSO-PB CI-1000 (manufactured by Nippon Soda Co., Ltd.), and 217.96 g of cyclohexanone. The contents were stirred at 40°C for 1 hour.

Thereto were further added 10.91 g (67.68 mmol) of p-isopropylphenyl isocyanate and 0.54 g (2.82 mmol) of 3-methyl-1-phenyl-2-phospholene 2-oxide. The resultant mixture was heated to 100°C with stirring and held for 2 hours.

The progress of the reactions was ascertained by IR analysis. Specifically, the decrease in absorption by the stretching vibration of the atomic group N=C=O in the isocyanates (2,270 cm⁻¹) and the increase in absorption by the stretching vibration of the atomic group N=C=N in the polycarbodiimide (2,135 cm⁻¹) were followed. Furthermore, absorption by the stretching vibration of the C=O in the amide group at each linkage between each bifunctional liquid rubber and the diisocyanate (1,695 cm⁻¹) was observed. After the end point of the reactions was ascertained by IR analysis, the reaction mixture was cooled to room temperature. Thus, a polycarbodiimide solution was obtained.

In the polycarbodiimide obtained, n₁+n₂ was 3 to 5, n₃ was 71 to 91, n₁+n₂+n₃ was 74 to 96, and (n₁+n₂) / (n₁+n₂+n₃) was from 5/74 to 3/96.

Subsequently, the polycarbodiimide solution obtained was applied with a roll coater on a separator (thickness, 50 µm; manufactured by Mitsubishi Polyester Film Corp.) consisting of a poly(ethylene terephthalate) film treated with a release agent (fluorinated silicone), in such an amount as to give a resin film having a thickness of 250 µm. This coating was heated at 130°C for 1 minute and then at 150°C for 1 minute to obtain a resin film adherent to the separator.

Through-holes of 0.3 mm-diameter were formed by punching in the resin film obtained. These through-holes were filled with a paste containing copper particles by means of a dispenser to form conduction paths.

A double-sided copper-clad substrate was prepared which comprised a polyimide resin as an insulating layer and a copper foil superposed as a conductor layer on each side of the insulating layer. The copper foils were etched to produce a wiring circuit board having a given wiring pattern on each side. Two such wiring circuit boards were prepared.

A semiconductor element having a thickness of 100 µm was mounted with a flip chip bonder on one side of each of the two wiring circuit boards.

Subsequently, the two wiring circuit boards were disposed respectively on both sides of the resin film so that the semiconductor elements faced each other. This assemblage was pressed with a vacuum pressing machine (VH1-572, manufactured by Kitagawa Seiki) under a vacuum of 2,660 Pa at a temperature of 150°C and a pressure of 2.94×10⁻¹ MPa for 30 seconds to conduct press bonding and embed the semiconductor elements.

Thereafter, the resultant structure was heated at 175°C for 5 hours to cure the polycarbodiimide in the resin layer. Thus, a circuit board having built-in electronic parts was produced.

The process of the invention is usable in the production of electronic appliances which necessitate the high-density mounting of electronic parts such as semiconductor elements.

While the present invention has been described in detail and with reference to specific embodiments thereof, it will be apparent to one skilled in the art that various changes and modifications can be made therein without departing from the spirit and scope thereof.

The present application is based on Japanese Patent Application No. 2004-010372 filed on January 19, 2004, the contents thereof being herein incorporated by reference.

## Claims

1. A process for producing a circuit board having built-in electronic parts, which comprises the steps of:
disposing two wiring circuit boards each having an electronic part mounted thereon so that the electronic-part-mounting sides of the respective circuit boards face each other;
disposing a resin layer between the circuit boards; and
press-bonding the resin layer to the circuit boards.

2. A process for producing a circuit board having built-in electronic parts, which comprises the steps of:
folding a wiring circuit board having two or more electronic parts, mounted thereon;
disposing a resin layer in the resultant space between sections of the folded circuit board where electronic-part-mounting sides have come to face each other; and
press-bonding the resin layer to the folded sections of the circuit board.

3. The process for producing a circuit board having built-in electronic parts of claim 1 or 2, wherein the resin layer comprises a polycarbodiimide.

4. The process for producing a circuit board having built-in electronic parts of claim 3, wherein the polycarbodiimide comprises:
n₁ pieces of structural units represented by general formula I: 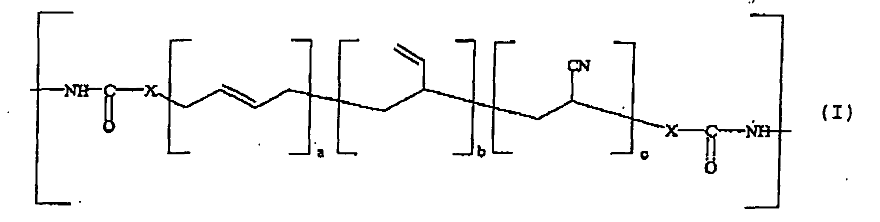 wherein a, b and c each are an integer of 0 to 200, provided that at least one of a, b and c is not 0, and X represents a single bond or an alkylene group having 1 to 5 carbon atoms;
n₂ pieces of structural units represented by general formula II: 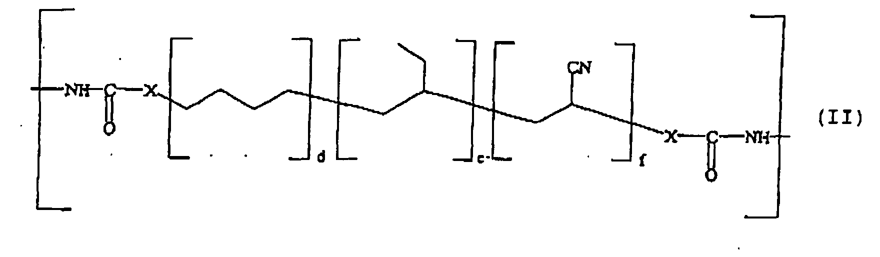 wherein d, e and f each are an integer of 0 to 200, provided that at least one of d, e and f is not 0, and X represents a single bond or an alkylene group having 1 to 5 carbon atoms; and
n₃ pieces of structural units represented by general formula III: 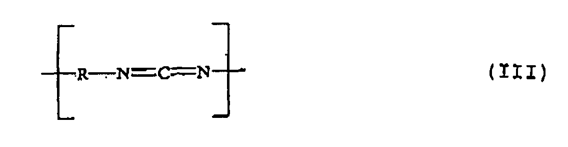 wherein R represents a bivalent organic group having 4 to 40 carbon atoms, and
having terminal structural units obtained by reacting each end of the molecules with a monoisocyanate,
wherein n₁+n₂ is an integer of 2 or larger, n₃ is an integer of 1 or larger, n₁+n₂+n₃ is 3 to 1,500, and (n₁+n₂)/(n₁+n₂+n₃) is from 1/100 to 1/3.
